# EUROPEAN PATENT APPLICATION

(11) **EP 3 282 587 A1**
(43) Date of publication of application: **14.02.2018**
(21) Application number: 16188116.4
(22) Date of filing: 09.09.2016
(51) Int. Cl.: H03K 17/96

(54) **ELECTRONIC APPLIANCE WITH A BUTTON DEVICE**

(30) Priority: 12.08.2016 EP 16183906; 12.08.2016 EP 16183907
(71) Applicant: BIG KAISER PRÄZISIONSWERKZEUGE AG, 8153 Rümlang (CH)
(72) Inventor: STADELMANN, Ralph, 8180 Bülach (CH); FENOLLOSA, Jose Maria, 6331 Hünenberg (CH)
(74) Representative: Rutz, Andrea

(57) **Abstract**

A boring head (1) or an electronic appliance other than a boring head (1) with an electronic control unit (60) and with a button device for enabling a user to influence the control unit (60) is provided. The button device comprises a button (49), a piezo diaphragm (50) and a piezo board (53) being connected to the piezo diaphragm (50). The button (49) is operatively connected to the control unit (60) and serves to be manipulated by a user. The piezo diaphragm (50) serves to detect a manipulation of the button (49) by the user based on piezoelectricity. The piezo board (53) is connected to the piezo diaphragm (50) by means of an anisotropic conductive adhesive (58).

## Description

### TECHNICAL FIELD

The present invention relates to a boring head or an electronic appliance other than a boring head with an electronic control unit and with a button device for enabling a user to influence the control unit. The invention also relates to a method for manufacturing a button device of such a boring head or appliance as well as to a button device of such a boring head or appliance.

### PRIOR ART

There is a large variety of appliances with an electronic control unit that can be influenced by a user by means of at least one button. The button, e.g. a push-button, can for example be used to switch the appliance on and off and/or to influence the signal processing being carried out by electronic control unit.

An exemplary appliance which can have a button for influencing an internal electronic control unit concerns a boring head as used for example for chip forming metal cutting. Boring heads often comprise a radially displaceable insert holder, in order to allow a radial adjustment of the cutting edge of the cutting insert. The extent of radial displacement of the cutting insert represents a crucial parameter of the boring head. In some cases, in particular in high-precision tooling and for offering a better comfort, the extent of radial displacement of the cutting insert is digitally indicated to the user by means of a display. On such boring heads, a button is usually provided, in order to switch on and off the display as well as the internal electronic control unit which serves to measure the displacement and to control the display. The button can provide further functionalities, such as for example a reset function.

A boring head comprising a display for digitally indicating the radial displacement of an insert holder is for example disclosed in DE 10 2013 217 911 A1.

In WO 2006/000746, a display and a button are arranged on an adjuster tool for manually adjusting the position of a cutting edge. Thus, the display and the button are not arranged directly on the boring head, but on a separate device.

A large variety of other boring heads and appliances other than boring heads are known which comprise a button device for influencing an internal electronic control unit.

The function of a certain type of button devices is based on piezoelectricity. These type of button devices comprise a piezo element which is adapted to detect a manipulation of the button by the user. By the provision of a piezo element, smallest movements of the button, which can even be in the micrometre-range, result can usually be detected. With a button based on piezoelectricity, a particularly tight sealing can be achieved, which is particularly advantageous with respect to boring heads, but also with respect to other applications.

Appliances that comprise at least one button device based on piezoelectricity are for example disclosed in EP 0 472 888, DE 10 2013 212 573, DE 20 2013 001 457, GB 2 295 486, DE 198 11 372, EP 1 617 445 and EP 0 576 400.

In many appliances, the button device is often exposed to large external mechanical influences. In the case of boring heads, the respective components are usually exposed to high centrifugal forces during operation of the boring head. Due to the external mechanical influences, there is a risk of a loose connection with respect to the electric cables which are usually used to connect the piezo element to other electronic components. Thus, a failure of the appliance might occur due to an electric cable getting loose.

Moreover, the manufacturing of piezo-based button devices is usually complicated and laborious due to the connection of the piezo element to other electronic components by means of electric cables. For accommodating the electric cables and the contact points between the electric cables and the piezo element within the appliance, additional space is often needed.

### SUMMARY OF THE INVENTION

It is an object of the present invention to provide a boring head or an electronic appliance other than a boring head which has a button device that has a simple construction and a reduced risk of failure.

This object is solved by a boring head or appliance as claimed in claim 1. A button device of such a boring head or appliance is claimed in claim 13, and a method for manufacturing a button device of such a boring head or appliance is claimed in claim 14. Further embodiments of the invention are provided in the dependent claims.

The present invention provides a boring head or an electronic appliance other than a boring head with an electronic control unit and with a button device for enabling a user to influence the control unit, the button device comprising
a button, in particular a push-button, operatively connected to the control unit, for being manipulated by a user,
a piezo diaphragm, in order to detect a manipulation of the button by the user based on piezoelectricity, and
a piezo board connected to the piezo diaphragm.

The piezo board is connected to the piezo diaphragm by means of an anisotropic conductive adhesive.

Thus, the electric connection of the piezo diaphragm to the piezo board is achieved by the anisotropic conductive adhesive. Due to the application of the anisotropic conductive adhesive, no electric cables need to be provided for connecting the piezo board to the piezo diaphragm. Since the same element, i.e. the anisotropic conductive adhesive, is used for both electrically and mechanically connecting the piezo diaphragm and the piezo board, the manufacturing of the button device becomes particularly easy, and the risk for a failure of the appliance due to an electric cable getting loose is significantly reduced. By using an anisotropic conductive adhesive for connecting the piezo diaphragm to the piezo board, a particularly firm and space-saving connection of the piezo diaphragm can be achieved.

The principle of function of the button device is based on piezoelectricity. The piezo diaphragm is adapted to detect a manipulation of the button by the user. By the provision of a piezo diaphragm, smallest movements of the button, which can even be in the micrometre-range, can usually be detected. A movement of the button results in a deformation of the piezo diaphragm. Due to the deformation, an electric voltage is generated by the piezo diaphragm which can be used by the electronic control unit to detect a manipulation of the button by the user. With such a button device, a particularly tight sealing of the boring head or the appliance can be achieved.

The anisotropic conductive adhesive preferably comprises an electrically non-conducting glue in which electrically conductive particles are embedded. When pressing together the two components to be attached to one another, i.e. the piezo diaphragm and the piezo board, optionally under the influence of temperature (thermocompressing), the anisotropic conductive adhesive being arranged in-between is compressed such that at least some of the conductive particles get into contact with both components or that electrically conductive bridges between the two components are formed by the conductive particles. The electrically non-conducting glue is preferably an epoxy adhesive that advantageously cures at room temperature.

A boring head is an appliance that is usually regarded as belonging to tool industry. An electronic appliance other than a boring head can particularly be another appliance of the tool industry. It can, however, also be an appliance in another field than tool industry, such as for example an appliance in the field of vehicles, in particular motor vehicles, a household appliance, an appliance in the field of elevators or of conveying systems, an appliance in earth work or shipbuilding or an appliance in medical technology.

A particularly simple construction can be achieved, if the piezo board has the form of a printed circuit board (PCB). The piezo board can serve as a connector element for connecting the button device to the electronic control unit or, in particular if the piezo board is formed as a PCB, the electronic control unit can be directly integrated in the piezo board.

The piezo diaphragm preferably comprises a metal disc and a ceramic substrate applied to the metal disc. The metal disc is advantageously formed by a foil. The metal disc preferably has a circular shape, and the ceramic substrate is advantageously arranged concentrically on the metal disc.

In a preferred embodiment, the piezo board comprises an annular contact surface for contacting the periphery of the metal disc and a central contact surface for contacting the ceramic substrate.

Preferably, the device comprises a cover plate that forms the button. A pressure applied on the cover plate by a user is transmitted onto the piezo diaphragm which, as a result, is deformed in e.g. the micrometre-range. Due to the deformation, an electric voltage is generated by the piezo diaphragm.

Preferably, the piezo board is attached to the cover plate by means of the anisotropic conductive adhesive. Thus, the anisotropic conductive adhesive preferably not only serves to attach the piezo board to the piezo diaphragm, but also to attach the piezo board to the cover plate, which results in a particularly simple construction of the button device.

The cover plate preferably comprises a first indentation that serves to accommodate the piezo diaphragm and the piezo board. For this purpose, the first indentation advantageously corresponds in shape and size to the piezo board. By providing the first indentation, the piezo diaphragm and the piezo board can be protected optimally from external influences.

Since the piezo diaphragm usually concerns a particularly sensitive element, the cover plate preferably comprises a second indentation being present within the first indentation. The second indentation serves to accommodate the piezo diaphragm and advantageously corresponds in shape and size to the piezo diaphragm.

The piezo board preferably comprises contact surfaces for contacting respective contact elements of the control unit, in order to transmit electric signals from the piezo diaphragm to the control unit.

The button device can additionally comprise a compartment for a power source, such as a battery. The power source can particularly serve to provide electric energy to the control unit. The piezo diaphragm is advantageously arranged between the compartment for the power source and a cover that forms the button. Preferably, the piezo board is arranged between the compartment for the power source and the piezo diaphragm.

In a particularly preferred embodiment which is set out in the following, the appliance is a boring head with an electronic unit integrated in the boring head, the electronic unit comprising
a control unit,
a display being connected to the control unit, for displaying information concerning the status of the boring head to a user, and
a compartment for a power source to supply the control unit and the display with electric power.
The electronic unit as a whole is preferably designed as a compact subassembly of the boring head, and the button device advantageously forms a part of the electronic unit.

The boring head is adapted to transfer a rotational movement from a driving source, e.g. a spindle in a machine tool, to e.g. a cutting insert for machining a work piece. The cutting insert can particularly be adapted for chip forming metal cutting. The boring head usually comprises a main body to which the electronic unit is attached and which preferably comprises a stem portion and a head portion. The stem portion is preferably essentially cylindrical, but can also be cone-shaped or have a polygonal cross-section. The head portion is preferably essentially cylindrical. The stem portion usually serves to connect the boring head to a driving source e.g. a spindle in a machine tool. Attached to the head portion are usually the cutting insert for machining a work piece and preferably also the electronic unit. The electronic unit forms an integral part of the boring head and is usually arranged completely inwardly of the cutting insert, at least of the radially outermost edge of the cutting insert.

Being designed as a compact subassembly in respect to the electronic unit means that the electronic unit represents a module-like component that is clearly delimited from the rest of the boring head. Thus, the electronic unit as a whole forms a separate and clearly delimited structural component with respect to the other components of the boring head. The different components of the electronic unit, i.e. at least the control unit, the display and the compartment for the power source, are usually arranged closely together and all electric lines that interconnect these different components preferably extend within the electronic unit and not through other parts of the boring head. Optionally, the electronic unit can be non-destructively detachable as a whole from the boring head by means of only a few simple manipulations, such as by loosening some screws, and in such a way, that the electronic unit forms a single, compact piece after having been detached from the boring head.

Due to its compact construction in the form of a subassembly, the electronic unit can be produced completely separately from the rest of the boring head. Since all electric lines for interconnecting the components of the electronic unit preferably completely extend within the electronic unit, the number of electric cables being present within the boring head can be reduced significantly. Advantageously, in order to further reduce the risk of failure, the electronic unit does not comprise any electric cables at all, but only electric connections in the form of contacts, printed circuits etc. Due to the compact construction of the electronic unit, the boring head can optionally be constructed such that the electronic unit can easily be detached from the main body, for example for cleaning purposes or for replacement. Furthermore, an electronic unit with a compact construction can be sealed optimally with respect to dirt particles and liquid. Thus, the boring head also has a reduced risk of failure.

Usually, if the appliance is a boring head, the control unit is connected to some type of sensor that serves to measure a parameter of the boring head. The sensor can, but does not have to be part of the electronic unit. The parameter is preferably the radial position of the cutting insert being attached to the boring head. The control unit is preferably adapted to process the input data received from the sensor to an output signal that serves as the input signal for the display to indicate a respective value. For this purpose, the control unit usually comprises at least an analog-digital converter or a serial communication port such as a Universal Asynchronous Receiver Transmitter (UART), a serial peripheral interface (SPI) or an inter-integrated circuit (I²C). The display preferably comprises a liquid-crystal display (LCD) or a DOT Matrix or a TFT or E-Paper.

The power source is preferably represented by a customary battery. In a particularly preferred embodiment, the compartment is adapted to accommodate a button battery, which is particularly space-saving. Within the compartment, respective contact elements are usually provided, in order to electrically connect the power source to the control unit and to the display.

In a preferred embodiment, the button device which is preferably part of the electronic unit is designed as a push-button and is operatively connected to the control unit, in order to enable the user to influence the control unit. The button preferably serves to switch on and off the electronic unit and particularly the display. Depending on e.g. the order or duration of its operation, the button can provide further functionalities, such as for example a reset-function.

A particularly space-saving arrangement can be achieved, if the compartment for the power source is arranged between the control unit and the button.

Usually, a cover is provided for covering the compartment for the power source. The cover is preferably removably attached to the boring head, for example by means of screws, such that the power source can easily be replaced when needed. The button is preferably formed by the cover of the compartment. Such a design of the electronic unit is particularly space-saving.

The boring head can comprise a radially displaceable insert holder and a sensor for measuring the radial displacement of the insert holder. The sensor is preferably connected to the control unit, and the control unit is adapted to control the display such, that the radial displacement of the insert holder is indicated by the display.

The electronic unit advantageously comprises a casing in or on which the control unit, the display, the compartment for the power source, and preferably also the button are arranged. By providing such a casing, a particularly compact electronic unit can be achieved that can be produced separately from rest of the boring head. Thus, in such an embodiment, the casing, together with the control unit, the display, the compartment for the power source, and preferably also with the button, forms a separate subassembly of the boring head which can be attached to the main body for example by means of only a few fixing screws.

The control unit is preferably provided as a printed circuit board (PCB). The PCB advantageously comprises a signal processing unit and/or a memory chip.

The PCB advantageously forms a side wall of the electronic unit. It can particularly form the backside, i.e. the backside wall, of the electronic unit.

In a preferred embodiment, the PCB and the casing together form an inner space of the electronic unit, in which inner space the display and the compartment for the power source are arranged, in particular completely arranged. The electronic elements of the button, e.g. the piezo element, are preferably also arranged in this inner space.

The electronic unit is preferably adapted for wireless communication with an external device, such as a computer or a mobile phone. The electronic unit can particularly be adapted for wireless communication according to the "Bluetooth Low Energy"-standard. For wirelessly transmitting data from the control unit to an external device, the electronic unit preferably comprises an antenna. Advantageously, a window of the casing of the electronic unit is used to transmit the antenna radiation to the outside. Thus, the antenna is adapted to radiate electromagnetic waves through the window of the casing. The window is preferably a display window which allows the user to see the display. Advantageously, the antenna comprises a radiofrequency (RF) ground plane integrated in the PCB and a conductive element being formed by the casing of the electronic unit. The ground plane and the conductive element form the two legs of the antenna. The ground plane is advantageously arranged directly on the backside of the display window.

The main body preferably comprises a recess which is preferably open in the radial direction. The electronic unit is advantageously arranged within this recess. The recess is preferably provided in the head portion, in particular within an essentially cylindrical side wall of the head portion.

Of course it is also possible to use the electronic unit with the design as specified above in other appliances, i.e. in appliances other than boring heads. The appliance can be an appliance in the field of tool industry, but also in another field than tool industry.

The present invention also relates to a button device of a boring head or of an appliance as indicated above.

Furthermore, the present invention also relates to a method for manufacturing a button device of a boring head or of an electronic appliance other than a boring head, in particular a method for manufacturing a button device of a boring head or appliance as set out above, the button device comprising a piezo diaphragm and a piezo board and the method comprising at least the following steps:
- applying an anisotropic conductive adhesive to the piezo diaphragm or to the piezo board,
- bringing the piezo diaphragm and the piezo board together, such that the anisotropic conductive adhesive gets into contact with each of the piezo board and the piezo diaphragm, and
- pressing the button device such that the piezo diaphragm and the piezo board are moved closer to each other.

The method steps are usually carried out in the temporal order as indicated.

The pressing can be a thermocompressing carried out under the influence of a temperature of for example 180 - 200°C.

### BRIEF DESCRIPTION OF THE DRAWINGS

Preferred embodiments of the invention are described in the following with reference to the drawings, which are for the purpose of illustrating the present preferred embodiment of the invention and not for the purpose of limiting the same. In the drawings,
- Fig. 1: shows a perspective view of a boring head according to an inventive embodiment;
- Fig. 2: shows a top view of the boring head of Fig. 1;
- Fig. 3: shows a side view of the boring head of Fig. 1, a part of which is centrally cut out;
- Fig. 4: shows a plan view on the front of the electronic unit of the boring head of Fig. 1, without battery cover;
- Fig. 5: shows a perspective front view of the electronic unit of the boring head of Fig. 1, without battery cover;
- Fig. 6: shows a perspective back view of the electronic unit of the boring head of Fig. 1, without battery cover;
- Fig. 7: shows a cross-sectional perspective back view of the electronic unit of the boring head of Fig. 1 along the line VII-VII as depicted in Fig. 4, without battery cover;
- Fig. 8: shows a perspective exploded view of the of the electronic unit of the boring head of Fig. 1, without battery cover;
- Fig. 9: shows a plan view on the front of the battery cover of the electronic unit of the boring head of Fig. 1;
- Fig. 10: shows a perspective front view of the battery cover of the electronic unit of the boring head of Fig. 1;
- Fig. 11: shows a perspective back view of the battery cover of the electronic unit of the boring head of Fig. 1;
- Fig. 12: shows a cross-sectional view of the battery cover of the electronic unit of the boring head of Fig. 1;
- Fig. 13: shows an enlarged view of the area marked with dashed lines in Fig. 12, during production of the battery cover before being pressed;
- Fig. 14: shows an enlarged view of the area marked with dashed lines in Fig. 12, during production of the battery cover after being pressed;
- Fig. 15: shows an exploded perspective front view of the battery cover of the electronic unit of the boring head of Fig. 1;
- Fig. 16: shows an exploded perspective back view of the battery cover of the electronic unit of the boring head of Fig. 1;
- Fig. 17: shows a perspective view of the boring head of Fig. 1 when wirelessly transmitting data by means of an integrated antenna; and
- Fig. 18: shows a plan view on the front of the PCB of the electronic unit of the boring head of Fig. 1.

### DESCRIPTION OF PREFERRED EMBODIMENTS

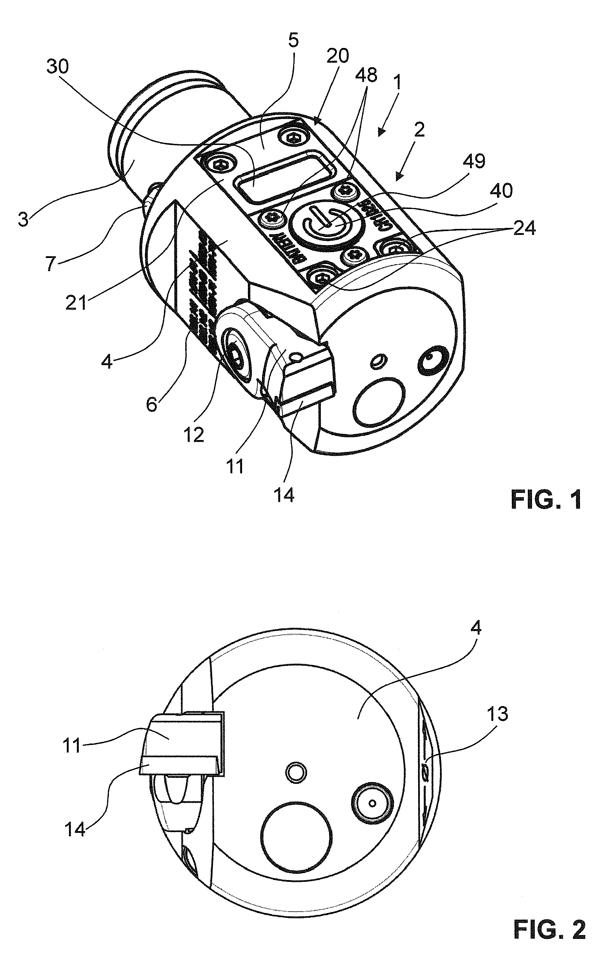

In figures 1 to 18, a boring head 1 comprising an inventive button device with a button 49, a piezo diaphragm 50 and a piezo board 53 as well as one or several parts of this boring head 1 are shown. Of course, the embodiment as illustrated in figures 1 to 18 and as disclosed in the following description with respect to these figures only concerns an exemplary embodiment. It is well understood that the button device as disclosed with respect to the boring head 1 in the following description could be used with any other electronic appliance and form a part thereof. The electronic appliance can be, but does not not necessarily need to be an appliance in the field of the tool industry. The appliance can well be an appliance of another field than the tool industry.

In the following, all indications of positions and directions, such as above, under, in- and outwardly are related to the radial direction of the boring head 1 being directed perpendicular to the rotation axis as defined by the usual direction of rotation of the boring head in normal use, i.e. when machining a work piece. The front side of an element of the boring head 1 usually means the side of the element which is directed radially outwardly and, thus, can represent a visible element to the user. The backside usually is the side of the element which is directed radially inwardly.

The boring head 1, as shown in figure 1, comprises a main body 2 being made as a whole in one piece. The main body 2 comprises a generally cylindrical stem portion 3 and an essentially cylindrical head portion 4. The stem portion 3 which has a smaller diameter than the head portion 4 serves to connect the boring head 1 to a driving source such as a spindle of a machine tool. In operation of the boring head 1, the driving source which is not shown in the figures effects a rotational movement of the boring head 1. For this purpose, the stem portion 3 is attached to the driving source in a torque-proof manner, such that the boring head 1 can transfer the rotational movement of the driving source to the cutting insert 14 which is adapted for chip forming metal cutting, i.e. for acting directly on a work piece to be machined.

For securing the boring head 1 in a torque-proof manner on the driving source of a boring or milling machine, a bolt 7 is displaceably arranged in the stem portion 3. The bolt 7 extends transversely, i.e. radially, through the stem portion 3.

Due to the essentially cylindrical shapes of the stem portion 3 and the head portion 4, a central longitudinal axis and a radial direction of the boring head 1 are defined. The central longitudinal axis coincides with the rotational axis of the boring head 1 in normal use.

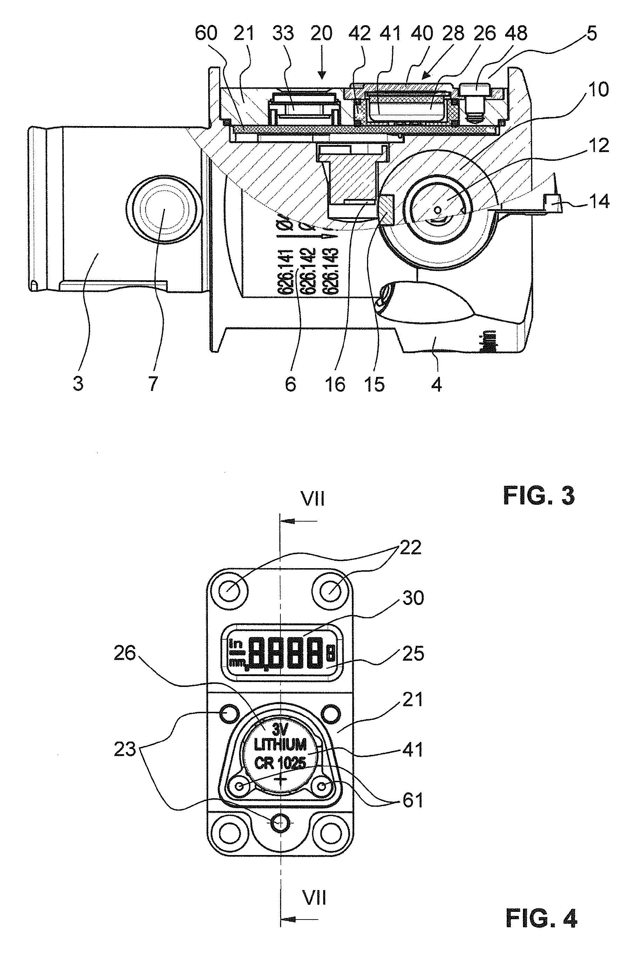

The head portion 4 of the boring head 1 comprises a transverse, i.e. radial, channel diametrically extending throughout the head portion 4. Within this channel, a tool carrier 10 in the form of a plunger is arranged (see figure 3). An insert holder 11 is attached to a first end-face of the tool carrier 10 outside of the channel. The insert holder 11 is attached to the tool carrier 10 by means of a clamping screw 12. The insert holder 11 holds a cutting insert 14 which has a cutting edge being adapted to directly act on a work piece for chip forming metal cutting. Along the radial direction, the cutting edge of the cutting insert 14 represents the outermost part of the boring head 1.

Attached to the second end-face of the tool carrier 10 is an adjusting screw 13 by which the tool carrier 10 can be displaced along the radial direction. The adjusting screw 13 has a hexagon socket for rotating the adjusting screw 13 by means of a corresponding hex key. Upon rotation of the adjusting screw 13, the tool carrier 10 is displaced along the radial direction. A scale can optionally be printed on the adjusting screw 13, in order to indicate the approximate displacement of the tool carrier 10 to the user.

On the head portion 4, an inscription 6 can be provided, in order to provide certain information to the user, such as for example information concerning different cutting inserts 14 and/or insert holders 11 that can be used in combination with this boring head 1.

On a side of the head portion 4 which is directed in a perpendicular direction relative to the longitudinal extension of the tool carrier 10, a recess 5 is provided. The recess 5 defines a cuboid and outwardly open inner space of the head portion 4. The inner space of recess 5 serves to accommodate an electronic unit 20.

The electronic unit 20 serves to calculate the actual radial displacement of the tool carrier 10 and to indicate a corresponding displacement value on a display 30 to the user. For this purpose, the electronic unit 20 comprises a battery compartment 26 for a customary battery 41, a display 30, a push-button 49 and a printed circuit board (PCB) 60. All of these electric components of the electronic unit 20 are interconnected with each other internally, such that the battery 41 can supply electric power to the PCB 60 and to the display 30 and that the user can influence the signal processing of the PCB 60 and thus the indication on the display 30 by pressing the push-button 49. The entire electronic unit 20 is integrated in the head portion 4 of the boring head 1.

For measuring the actual radial displacement of the tool carrier 10, a measuring area 15 is provided on the tool carrier 10, as can be seen in figure 3. The measuring area 15 is arranged directly adjacent a stationary sensor 16 which is adapted to measure radial displacements of the measuring area 15 relative to the sensor 16. The sensor 16 can for example be a hall-sensor or Anisotropic Magneto Resistor and the measuring area 15 a permanent magnet.

The sensor 16 is electrically connected to the PCB 60 of the electronic unit 20, such that a signal reflecting the actual displacement of the tool carrier 10 can be transferred to the PCB 60. The PCB 60 comprises contact elements or surfaces on its backside for contacting respective contact elements being connected to the sensor 16.

As can be seen in figures 4 to 7, the electronic unit 20 as a whole has an essentially cuboid outer shape that fits into recess 5 of the head portion 4. The outer shape of the electronic unit 20 is mainly defined by an electronic casing 21 which as a whole is made from a metal and in one piece. The electronic casing 21 has an inner space in which the display 30 and the battery compartment 26 are arranged completely. This inner space is delimited by the electronic casing 21 as well as by the PCB 60 which forms the backside of the electronic unit 20. Thus, as a whole, the electronic unit 20 has a compact construction.

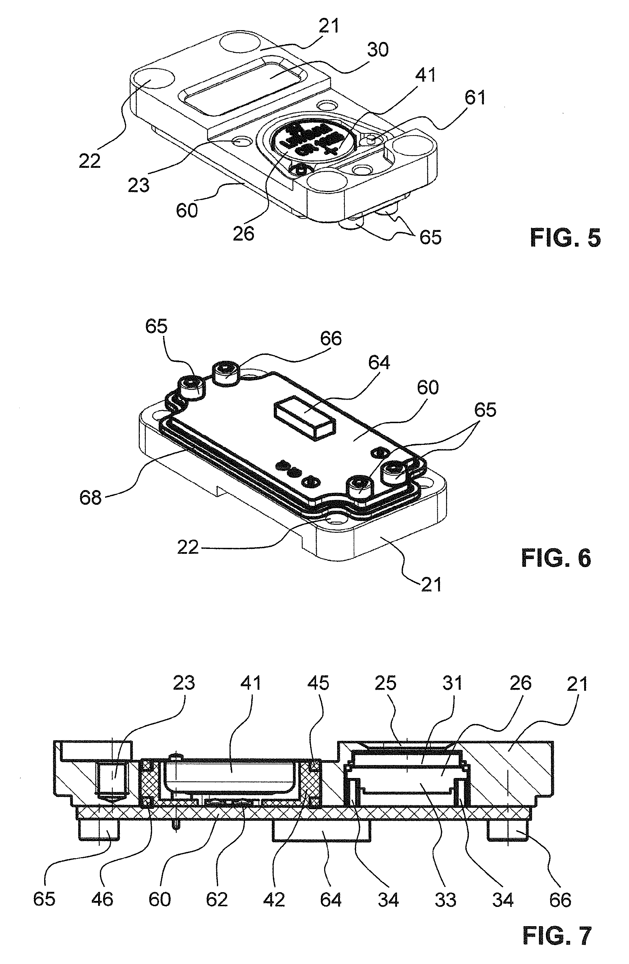

The electronic casing 21 forms a circumferential, essentially rectangular lateral frame which laterally delimits the electronic unit 20 and its electronic components with respect to the side walls of the recess 5. The inner space of the electronic casing 21 is divided into two compartments, a first compartment for accommodating the display 30 and a second compartment for accommodating the battery 41. Both compartments of the inner space are laterally delimited in all directions by the electronic casing 21 and are delimited backwards by the PCB 60. Towards the front, the first compartment of the inner space is delimited by a transparent display cover glass 31 which is inserted into a rectangular display window 25 formed by the electronic casing 21 (see figures 4 and 7). The second compartment of the inner space is delimited towards the front by a removable battery cover 28 (figure 3), such that the battery compartment 26 is arranged between the battery cover 28 and the PCB 60.

For attaching the electronic unit 20 to the head portion 4 of the boring head 1, a screw hole 22 is provided in each corner of the electronic casing 21, as can be seen in figures 4 to 6. The PCB 60 comprises corresponding cut-outs in each of its corners (figure 6). For fixing the electronic unit 20 on the main body 2 of the boring head 1, fixing screws 24 (figure 1) are guided through the screw holes 22 and screwed into respective threaded holes which are correspondingly provided on the main body 2 for this purpose. Thus, the electronic unit 20 forms a compact subassembly of the boring head 1 that can be produced completely separately from the rest of the boring head 1. After its production, the electronic unit 20 as a whole can simply be screwed to the main body 2 by means of the fixing screws 24.

In order to achieve an overall essentially flat front surface of the completely assembled electronic unit 20, the electronic casing 21 comprises an indentation in its front surface in the area of the battery compartment 26 for accommodating the battery cover 28. The indentation is dimensioned such, that it is laterally completely filled out by the battery cover 28 and that the front face of the battery cover 28 comes to lie flush with the adjacent front face of the electronic casing 21. Threaded holes 23 are provided on the electronic casing 20 for fixing the battery cover 28 on the electronic casing 20 by means of fixing screws 48.

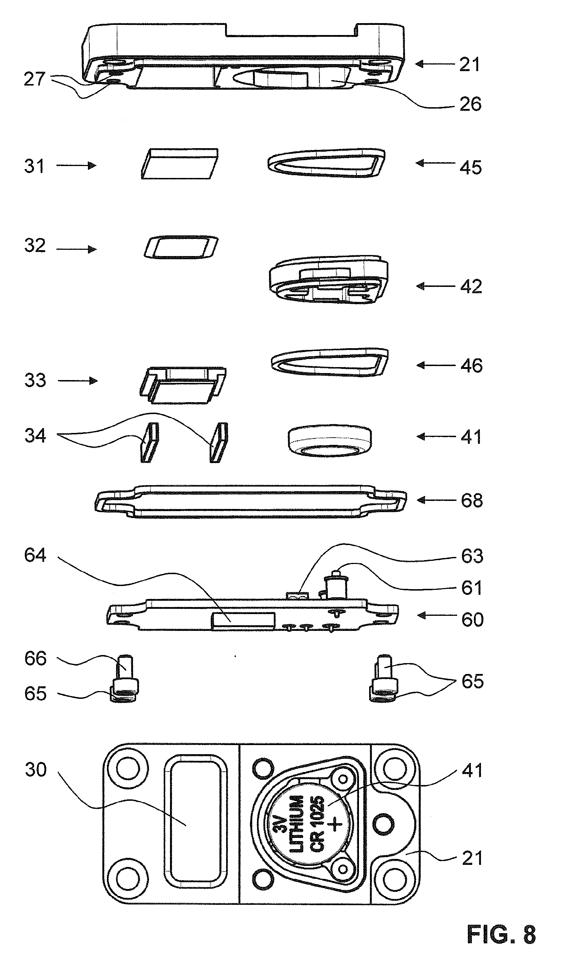

The display 30, the construction of which can be seen in figure 8, comprises the display cover glass 31, a separating foil 32, a liquid crystal display (LCD) 33 and two zebra strip connectors 34.

The display cover glass 31 is arranged in the display window 25 of the electronic casing 21 and serves to protect the LCD 33 from external mechanical influences, dirt particles and moisture. The separating foil is arranged between the display cover glass 31 and the LCD 33.

The LCD 33 serves to indicate the radial displacement of the tool carrier 10 and thus of the cutting insert 14 to the user. For this purpose, the LCD 33 is electrically connected by means of the zebra strip connectors 34 to an array of connector surfaces provided on the PCB 60. The zebra strip connectors 34 at the same time serve as spacers for arranging the LCD 33 close to the display cover glass 31 and to the display window 25.

On the PCB 60, which forms a control unit of the electronic unit 20, various electronic components 64 are arranged which are mutually interconnected by corresponding conductor tracks. The electronic components 64 of the PCB 60 usually encompass an analog-digital converter for converting the input signals received from the sensor 16 into digital data as well as a signal processing unit for processing the digital data and for providing a corresponding input signal to the LCD 33. The PCB 60 can also comprise a memory chip for storing the measured displacement data. The electronic components 64 are preferably arranged on the backside of the PCB 60.

On the front side of the PCB 60, contact elements 62 and 63 for contacting the battery 41 are provided - bottom battery contacts 62 for contacting a first pole of the battery 41 and a lateral battery contact 63 for contacting a second pole of the battery 41 which here has the form of a button battery, in particular a CR 1025 lithium battery.

Further contact elements 61 are provided on the front side of the PCB 60, which serve to contact the push-button 49. Due to the integration of the push-button 49 in the removable battery cover 28 which is explained in detail below, the contact elements 61 are constructed as spring contacts.

For fixing the PCB 60 on the electronic casing 21 by means of three fixing screws 65 and an antenna connecting screw 66 (the further function of which will be explained later), the PCB comprises screw holes 69 which correspond to threaded holes 27 being provided on the backside of the electronic casing 21. A main sealing 68 is arranged between the electronic casing 21 and the PCB 60, in order to protect the inside of the electronic unit 20 and of the boring head 1 from the entering of dirt particles and of moisture.

The second compartment of the inner space of the electronic unit 20 comprises the battery compartment 26 for accommodating a button battery 41. As can be seen in figure 7 and 8, a battery casing 42 is arranged within the second compartment. The battery casing 42 is made from a non-conducting material, such as a plastic, and delimits the battery compartment 26 laterally and at least partly towards its backside. A lower battery sealing 46 is provided for sealing the battery casing 42 against the PCB 60 and the electronic casing 21, and an upper battery sealing 45 is provided for sealing the battery casing 42 against the battery cover 28 and the battery casing 42.

The battery casing 42 comprises an opening on its backside, such that the bottom battery contacts 62 and the lateral battery contact 63 can protrude into the battery compartment 26 for contacting the battery 41.

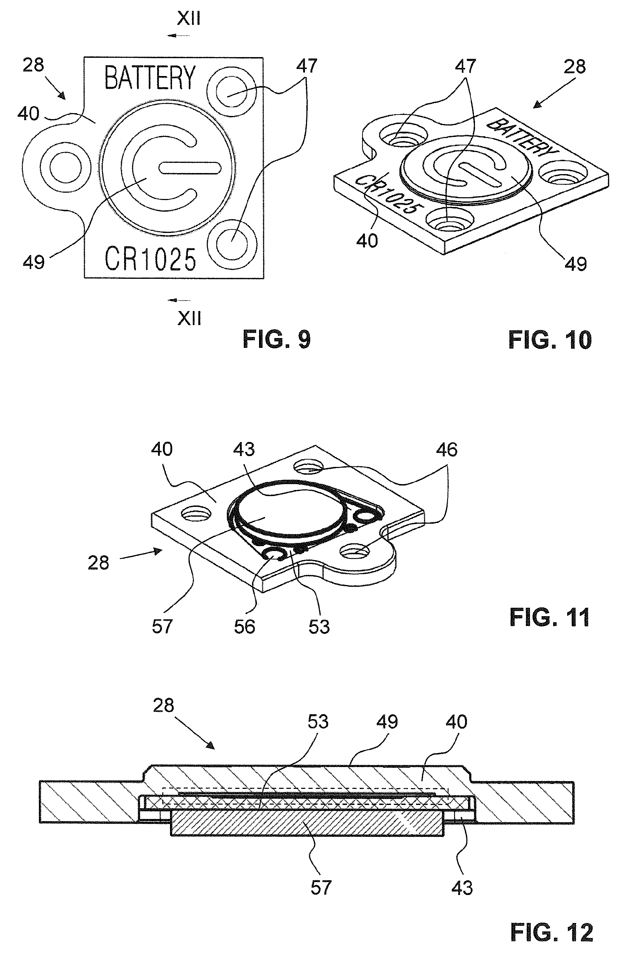

The construction of the battery cover 28 which also forms a push-button 49 is shown in figures 9 to 16. The battery cover 28 comprises a cover plate 40 which is made as a whole in one piece and from a metal. This cover plate 40 has a substantially flat configuration with a central elevation that forms the push-button 49 on its front side.

Three screw holes 47 are provided in the cover plate 40 of the battery cover 28. The screw holes 47 serve to removably fix the battery cover 28 on the electronic casing 21 by means of fixing screws 48.

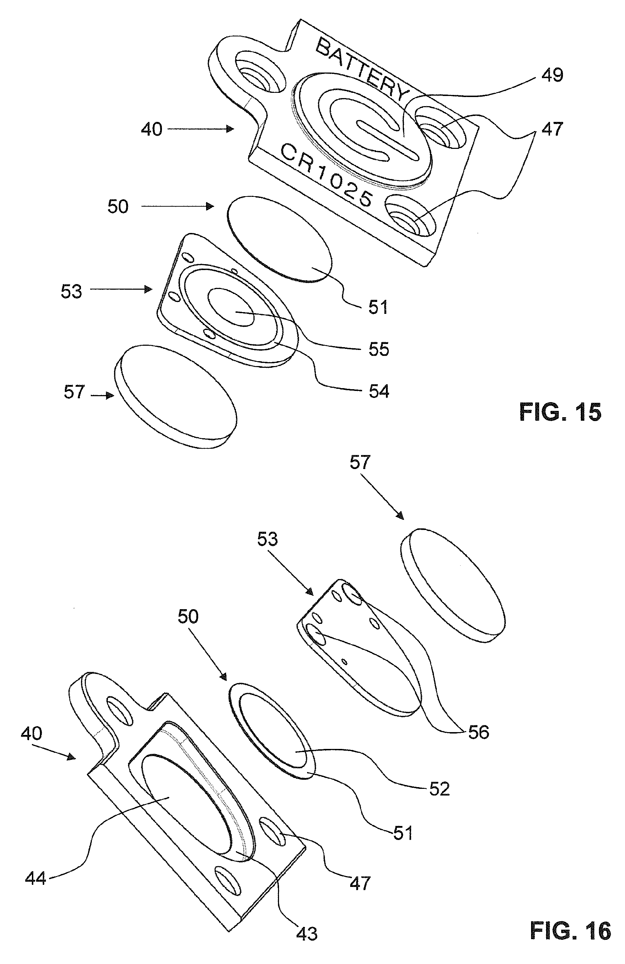

On its backside, the cover plate 40 comprises an indentation 43 within which a further indentation 44 is present (see figure 16). The indentations 43 and 44 serve to accommodate a piezo diaphragm 50, a piezo board 53 and a battery spacer 57. The indentation 43 corresponds in shape and size to the piezo board 53 and is adapted to accommodate the piezo board 53. The indentation 44 corresponds in its circular shape and size to the piezo diaphragm 50 and serves to accommodate the piezo diaphragm 50. The piezo diaphragm 50 and the piezo board 53 represent the electronic components of the push-button, which are arranged between the battery compartment 26 and the cover plate 40.

The piezo diaphragm 50 has a construction as it is well known to the skilled person with a metal disc 51 and a ceramic substrate 52 applied to the backside of the metal disc 51. The metal disc 51 is a circularly shaped foil having approximately the same thickness as the depth of the indentation 44. The ceramic substrate 52 is applied as a circular surface coating concentrically to the metal disc 51. A small bending or deformation of the piezo diaphragm 50, in particular caused by a touch force load acting on the push-button 49, results in a variation of the electric voltage measured between the metal dish 51 and the ceramic substrate 52. The PCB 60 is adapted to detect such a variation of the electric voltage of the piezo diaphragm 50.

The electric connection of the metal disc 51 and of the ceramic substrate 52 to the contact elements 61 of the PCB 60 is achieved via the piezo board 53. For this purpose, the piezo board 53 which is designed as a printed circuit board comprises on its front side an annular contact surface 54 for contacting the periphery of the metal disc 51 and a central contact surface 55 for contacting the ceramic substrate 52. The annular contact surface 54 and the central contact surface 55 are each connected within the piezo board 53 to a respective contact surface 56 arranged on the backside of the piezo board 53. When the battery cover 28 is properly attached to the electronic casing 21, the contact surfaces 56 are each in contact with one of the contact elements 61 of the PCB 60, in order to transmit electric signals from the piezo diaphragm 50 to the PCB 60.

The battery spacer 57 is attached, for example by means of an adhesive, to the backside of the piezo board 53. The battery spacer 57 is made from a non-conductive plastic material and prevents the battery 41 from contacting the piezo board 53.

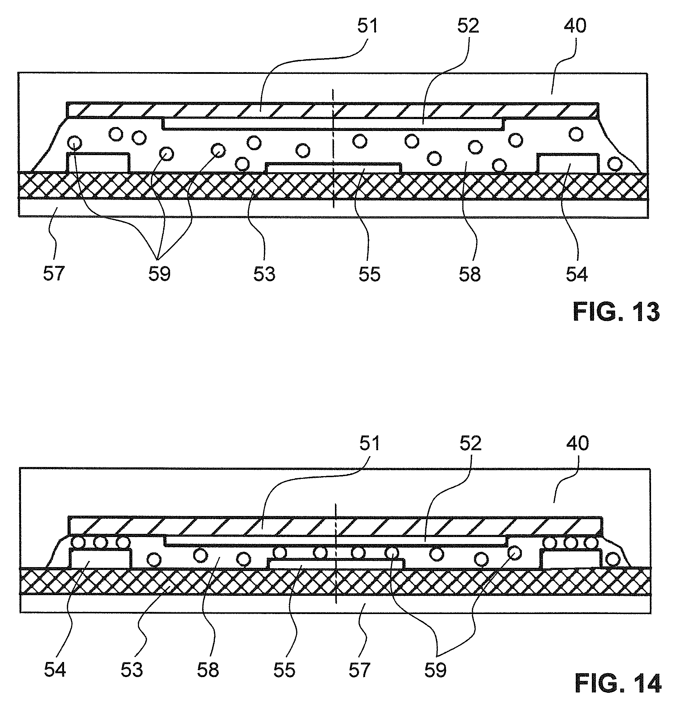

A crucial step in the production process of the battery cover 28 is illustrated in figures 13 and 14. It is illustrated how the piezo board 53 is attached to the piezo diaphragm 50 and the cover plate 40 by means of an anisotropic conductive adhesive 58: The anisotropic conductive adhesive 58 is applied to either the backsides of the piezo diaphragm 50 and the cover plate 40 or to the front side of the piezo board 53. The respective components are then brought together as intended, such that the anisotropic conductive adhesive 58 is in contact with each of the piezo board 53, the piezo diaphragm 50 and the cover plate 40. Electrically conductive particles 59 which are embedded in the anisotropic conductive adhesive 58 are arranged distant from each other and none of the conductive particles 59 is in contact with both the piezo board 53 and the piezo diaphragm 50. As a result, the anisotropic conductive adhesive 58 is non-conducting along all directions.

The battery cover 28 is then pressed in such a direction that the cover plate 40 and the piezo board 53 are moved closer each other (figure 14). The pressing can optionally be carried out under the influence of a temperature of typically 180 - 200°C (thermocompressing). Thereby, the conductive particles 59 are moved together, such that electrically conductive bridges are formed by the conductive particles 59 that reach from the metal disc 51 and from the ceramic substrate 52 of the piezo diaphragm 50 to the respective contact surfaces 54 and 55 of the piezo board 53. The piezo diaphragm 50 and the piezo board 53 can even be moved so close to each together, that single conductive particles 59 get into contact with both the piezo diaphragm 50 and the piezo board 53, as shown in figure 14. Thus, in this pressed final position of the battery cover 28, an electric contact is established by the anisotropic conductive adhesive 58 between the metal disc 51 of the piezo diaphragm 50 and the annular contact surface 54 of the piezo board 53 on the one hand and between the ceramic substrate 52 of the piezo diaphragm 50 and the central contact surface 55 of the piezo board 53 on the other hand. However, the anisotropic conductive adhesive 58 is still non-conductive along the directions perpendicular thereto.

By using the anisotropic conductive adhesive 58 for attaching the piezo diaphragm 50 to the piezo board 53, a particularly safe and space-saving mechanical and electrical connection between these two components can be achieved. Particularly good results were obtained by using the anisotropic conductive epoxy adhesive 124-19 of Creative Materials Inc., Ayer, US as the anisotropic conductive adhesive 58

The function of the push-button 49 in the present embodiment is programmed such in the PCB 60 that the electronic unit 20 and particularly the display 30 is switched on upon a first touch of the push-button 49 and that the indication of the radial displacement on the display 30 is reset to a zero-value upon a second touch of the push-button 49 that lasts longer than for one second.

The boring head 1 according to the present embodiment is adapted to wirelessly transmit data signals from the electronic unit 20 to an external device, such as a computer, a mobile phone or an adjuster tool for adjusting the adjusting screw 13. Thus, the data of radial displacement of the cutting insert 14 can not only be displayed on the display 30, but also on an external device.

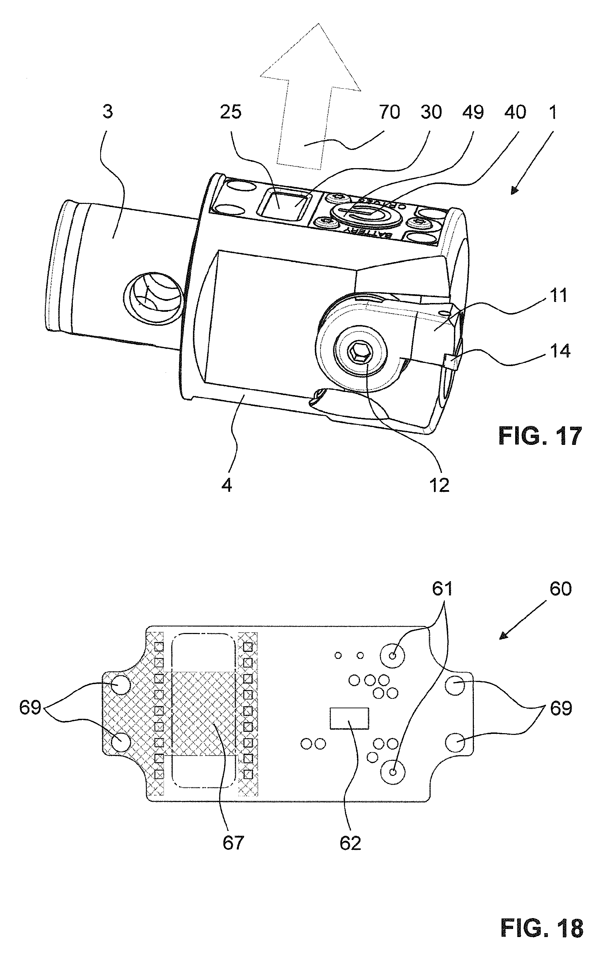

Figures 17 and 18 illustrate the adaptation of the boring head 1 to wirelessly transmit data signals to an external device. For this purpose, the boring head 1 comprises a transmission unit with an antenna that is adapted to send out electromagnetic waves. In the present embodiment, the transmission unit is adapted to wirelessly communicate with an external device according to the "Bluetooth Low Energy"-standard. Of course, other wireless communication standards could also be applied and the boring head 1 and in particular the transmission unit would be adapted accordingly in this case.

The transmission unit also comprises a Bluetooth-microcontroller arranged in the PCB 60 for generating the 2.4GHz Bluetooth signal as well as a matching circuit with a series of inductors and capacitors for adapting the impedance form the antenna to the one of the Bluetooth-microcontroller to the same 50Ω impedance in both directions, in order to minimize energy losses.

As shown in figure 17, the display window 25 is used for sending out the electromagnetic antenna radiation 70 from the electronic unit 20 to an external device. Thus, the antenna radiation 70 is transmitted through the display window 25 to the outside of the boring head 1.

In the present embodiment, the antenna for the wireless data transmission is formed by an internal radiofrequency (RF) ground plane 67 integrated in the PCB 60 in the area behind the display window 25 (see figure 18), by the antenna connecting screw 66 and by the electronic casing 21. The metallic and thus conducting electronic casing 21 represents the conducting element of the antenna exposed in space. The ground plane 67 and the conductive element, i.e. the electronic casing 21, form the two legs of the antenna. The antenna connecting screw 66 serves as a connection element between the PCB 60 and the conducting element, i.e. the electronic casing 21. Accordingly, the antenna connection screw 66 is made from an electrically conducting material, i.e. a metal such as aluminium, while the fixing screws 65 can be made from any material and also from less or non-conducting materials, such as a plastics material or titanium. For connecting the antenna connection screw 66 to an antenna feed on the PCB 60, the PCB 60 comprises a contact surface surrounding the corresponding screw hole 69. In the present embodiment, the ground plane 67 is designed as a rectangular area that covers a major part of the backside of the display window 25.

The invention is of course not limited to the preceding presented embodiment of a boring head and a plurality of modifications is possible. The button device comprising the button 49, the piezo diaphragm 50 and the piezo board 53 could be a part of any other electronic appliance, i.e. other than a boring head or even other than an appliance in the field of tool industry. In an alternative embodiment of a boring head, the stem portion 3 could also be cone-shaped or have a polygonal cross-section. Furthermore, the function of the sensor 16 and the measuring area 15 for measuring radial displacements of the tool carrier 10 could alternatively also be based on an optical, capacitive or inductive measurement. Instead of wirelessly communicating according to a "Bluetooth"-standard, the transmission unit could also be adapted to communicate according to ANT, ZigBee or any other standard. A plurality of further modifications is possible.

### LIST OF REFERENCE SIGNS

| | | | |
|---|---|---|---|
| 1 | Boring head | 41 | Battery |
| 2 | Main body | 42 | Battery casing |
| 3 | Stem portion | 43 | Indentation |
| 4 | Head portion | 44 | Indentation |
| 5 | Recess | 45 | Upper battery sealing |
| 6 | Inscription | 46 | Lower battery sealing |
| 7 | Bolt | 47 | Screw hole |
| | | 48 | Fixing screw |
| 10 | Tool carrier | 49 | Push-button |
| 11 | Insert holder | | |
| 12 | Clamping screw | 50 | Piezo diaphragm |
| 13 | Adjusting screw | 51 | Metal disc |
| 14 | Cutting insert | 52 | Ceramic substrate |
| 15 | Measuring area | 53 | Piezo board |
| 16 | Sensor | 54 | Annular contact surface |
| | | 55 | Central contact surface |
| 20 | Electronic unit | 56 | Contact surface |
| 21 | Electronic casing | 57 | Battery spacer |
| 22 | Screw hole | 58 | Adhesive |
| 23 | Threaded hole | 59 | Conductive particles |
| 24 | Fixing screw | | |
| 25 | Display window | 60 | PCB |
| 26 | Battery compartment | 61 | Contact elements |
| 27 | Threaded hole | 62 | Bottom battery contact |
| 28 | Battery cover | 63 | Lateral battery contact |
| | | 64 | Electronic component |
| 30 | Display | 65 | Fixing screw |
| 31 | Display cover glass | 66 | Antenna connecting screw |
| 32 | Separating foil | 67 | Ground plane |
| 33 | LCD | 68 | Main sealing |
| 34 | Zebra strip connector | 69 | Screw hole |
| 40 | Cover plate | 70 | Antenna radiation |

## Claims

1. A boring head (1) or an electronic appliance other than a boring head (1) with an electronic control unit (60) and with a button device for enabling a user to influence the control unit (60), the button device comprising
a button (49) operatively connected to the control unit (60), for being manipulated by a user,
a piezo diaphragm (50), in order to detect a manipulation of the button (49) by the user based on piezoelectricity, and
a piezo board (53) connected to the piezo diaphragm (50),
**characterized in that**
the piezo board (53) is connected to the piezo diaphragm (50) by means of an anisotropic conductive adhesive (58).

2. The boring head (1) or appliance as claimed in claim 1, wherein the button (49) is designed as a push-button.

3. The boring head (1) or appliance as claimed in claim 1 or claim 2, wherein the anisotropic conductive adhesive (58) comprises an electrically non-conducting glue in which electrically conductive particles are embedded.

4. The boring head (1) or appliance as claimed in one of the preceding claims, wherein the piezo board (53) is formed as a printed circuit board (PCB).

5. The boring head (1) or appliance as claimed in one of the preceding claims, wherein the piezo diaphragm (50) comprises a metal disc (51) and a ceramic substrate (52) applied to the metal disc (51).

6. The boring head (1) or appliance as claimed in claim 5, wherein the metal disc (51) is formed by a foil.

7. The boring head (1) or appliance as claimed in claim 5 or claim 6, wherein the piezo board (53) comprises an annular contact surface (54) for contacting the periphery of the metal disc (51) and a central contact surface (55) for contacting the ceramic substrate (52).

8. The boring head (1) or appliance as claimed in one of the preceding claims, wherein the button device comprises a cover plate (40) that forms the button (49).

9. The boring head (1) or appliance as claimed in claim 8, wherein the piezo board (53) is attached to the cover plate (40) by means of the anisotropic conductive adhesive (58).

10. The boring head (1) or appliance as claimed in claim 8 or claim 9, wherein the cover plate (40) comprises a first indentation (43), and wherein the first indentation (43) serves to accommodate the piezo diaphragm (50) and the piezo board (53) and preferably corresponds in shape and size to the piezo board (53).

11. The boring head (1) or appliance as claimed in claim 10, wherein the cover plate (40) comprises a second indentation (44) being present within the first indentation (43), and wherein the second indentation (44) serves to accommodate the piezo diaphragm (50) and preferably corresponds in shape and size to the piezo diaphragm (50).

12. The boring head (1) or appliance as claimed in one of the preceding claims, wherein the piezo board (53) comprises contact surfaces (56) for contacting respective contact elements (61) of the control unit (60), in order to transmit electric signals from the piezo diaphragm (50) to the control unit (60).

13. A button device of a boring head (1) or of an appliance as claimed in one of the preceding claims.

14. A method for manufacturing a button device of a boring head (1) or of an electronic appliance other than a boring head (1), in particular a method for manufacturing a button device of a boring head or appliance as claimed in one of claims 1 to 12, the button device comprising a piezo diaphragm (50) and a piezo board (53) and the method comprising at least the following steps:
- applying an anisotropic conductive adhesive (58) to the piezo diaphragm (50) or to the piezo board (53),
- bringing the piezo diaphragm (50) and the piezo board (53) together, such that the anisotropic conductive adhesive (58) gets into contact with each of the piezo board (53) and the piezo diaphragm (50), and
- pressing the button device such that the piezo diaphragm (50) and the piezo board (53) are moved closer to each other.

15. The method as claimed in claim 14, wherein the pressing is carried out under the influence of a temperature of 180 - 200°C.
